# EUROPEAN PATENT APPLICATION

(11) **EP 2 037 444 A1**
(43) Date of publication of application: **18.03.2009**
(21) Application number: 08164265.4
(22) Date of filing: 12.09.2008
(51) Int. Cl.: G09G 3/36, G02F 1/1362

(54) **Liquid crystal display**

(30) Priority: 14.09.2007 US 855432
(71) Applicant: TPO Displays Corp., Miao-Li County (TW)
(72) Inventor: Yeats, David, 6287 NG Eys (NL); Novoselov, Pavel, 6413 LW Heerlen (NL); Goldhoorn, Pieter, 5506 BL Veldhoven (NL)
(74) Representative: 2K Patentanwälte Kewitz & Kollegen

(57) **Abstract**

A liquid crystal display is provided to include a display panel with a plurality of pixels, which are arranged in rows and columns in a matrix form. Each pixel has a plurality of sub-pixels of first, second, third and fourth sub-pixel types, respectively, corresponding to red, green, blue and white (RGBW) colors and interleaved together. Each succession of first, second, and third sub-pixels form a first sub-pixel group, and a subsequent fourth sub-pixel forms a second sub-pixel group. The sub-pixels are arranged such that the second type of the sub-pixels and the fourth type of the sub-pixels are in a same column. In each row, the sub-pixel in a rightmost column is of the same sub-pixel type as the sub-pixel in a leftmost column of that row.

## Description

### TECHNICAL FIELD

The invention relates to a liquid crystal display, and more specifically to a color matrix display (e.g., LCD or OLED) with pixels arranged in rows and columns thereby forming a matrix, wherein each pixel is consisted of red, green, blue and white sub-pixels interleaved together such that the green sub-pixels are in the same column as the white sub-pixels, and the sub-pixels in leftmost column mirror the sub-pixels in the rightmost column.

### BACKGROUND

Liquid crystal displays (LCD-displays) are known in the field. Such LCD-display typically includes a number of pixel elements, usually arranged in a matrix formation, whereby each pixel element can be controlled individually to emit or block light. As a result, a moving image can be created by selectively controlling each pixel.

The LCD-display is generally formed by a stack of layers. One of the layers is an array of liquid crystal elements that can be controlled by electrode layers arranged to address specific pixels by applying a voltage to corresponding liquid crystal elements. By applying a voltage, the orientation of the molecules of the liquid crystal can be controlled in such a way that the liquid crystal element is in an opaque state, transparent state or semi-transparent state.

The liquid crystal and the electrodes are generally positioned between two polarizing filters. Light traveling through the stack of layers is blocked or allowed to pass depending on the orientation of the liquid crystal molecules (depending on the voltage applied to the liquid crystal) of each pixel and the orientation of the polarizing filters, relative to the orientation of the liquid crystal molecules.

According to one example, the polarizing filters are positioned so that polarizing directions are perpendicular to one another. The liquid crystals are placed between two electrode layers with each layer having electrodes parallel to the adjacent polarizing filter. If no voltage is applied to certain pixels, the molecules will align with the electrodes, and therefore be arranged in a helical structure (twist). Light passing through the first polarizing filter is rotated by this helical structure as it passes through the liquid crystal, and therefore allowing it to pass through the second polarizing filter.

However, once a voltage is applied to a pixel, with electrical field lines running from one electrode layer to another electrode layer, the helical structure can be disturbed under influence of the electrical field lines. As a result, no light can pass through this pixel as it is blocked by the second polarizing filter. This is also referred to as the 'normally not black' LCD-display DI (Liquid Crystal Display).

It will be understood that different variations for the above-discussed example are possible in practice. For instance, by changing the orientation of the polarizing filters, a 'normally black' LCD-display DI can be created (i.e. a LCD-display in which pixels appear substantially black when no voltage is applied).

Additionally, liquid crystals that are aligned in the direction of the passing light (homeotropically) between perpendicularly crossed polarizing filters gives perfect extinction of normally passing light. This non-driven dark state (normally black mode) is of high quality. Extinction occurs at all wavelengths and is independent of the birefringence and the thickness of the liquid crystal layer

In order to create a color LCD-display, each pixel can be divided in sub-pixels that may individually be addressed, each having their own liquid crystal. Each pixel can be divided according to the RGB-arrangement, i.e. each pixel can be divided in a red, a green and a blue sub-pixel, as known to one of ordinary skilled person. The colors are added to the arrangement by adding a separate color filter layer, for instance somewhere in between the polarizing layers. The color filter layer can be a matrix of adjacent color filters.

In order to further improve the performance of the LCD-display, each pixel may be divided according to the RGBW-arrangement, where each pixel is divided in a first, a second, a third and a fourth sub-pixel SP, and where the first, second, third and fourth sub-pixels can be a red sub-pixel, green sub-pixel, blue sub-pixel and white sub-pixel, respectively.

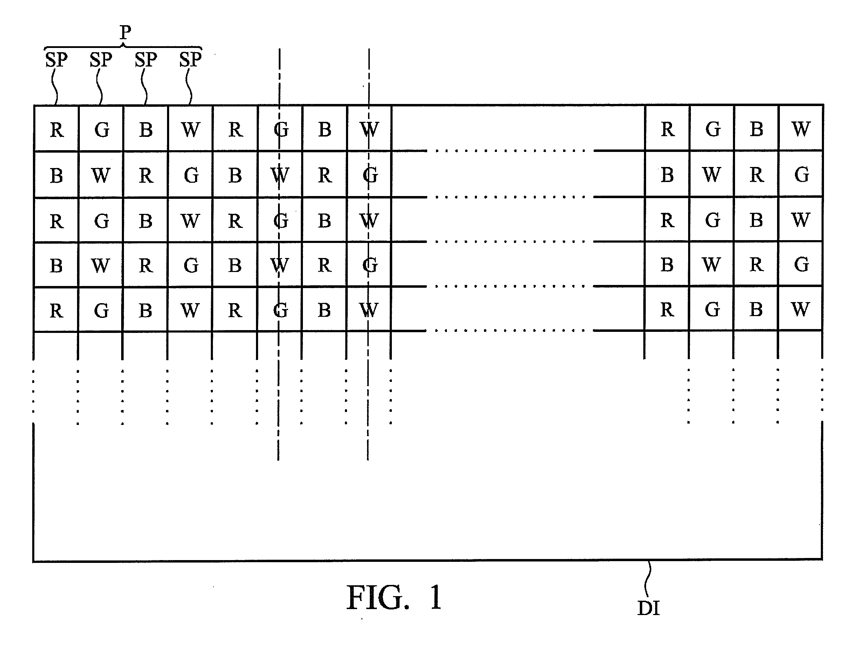

Fig. 1 illustrates the matrix lay-out of a conventional LCD-display DI with an RGBW-arrangement. The matrix lay-out comprises a number of rows (shown horizontally in Fig. 1) and columns (shown vertically in Fig. 1). Each row has a number of pixels P, each having four sub-pixels SP, i.e., a red, a green, a blue and a white sub-pixel SP. Instead of a white sub-pixel, other suitable colors may be chosen, such as yellow or cyan.

Different arrangements of the R, G, B and W sub-pixels SP can be used depending on the color schemes and specification. It has been found that one of the optimum arrangements is the one where the white sub-pixels SP of the even rows and the green sub-pixels SP of the odd rows are in the same column (where the white sub-pixels SP of the odd rows and the green sub-pixels SP of the even rows are in the same column), as schematically indicated by the two dashed vertical lines in Fig. 1.

In Fig. 1, the odd rows are arranged so as to consist of only complete pixels P (in this case ending with a white sub-pixel W). Due to the optimum arrangement of green and white sub-pixels in the same columns, the even rows therefore comprise incomplete pixels P and end with a green sub-pixel G.

The arrangement as shown in Fig. 1 can yield a decent image as perceived by a user. However, it has been found that the LCD-displays with the RGBW-arrangement of Fig. 1 suffer from color effects along the edges or borders of the display. Such is generally referred to as border effects. It is therefore an object of the invention to minimize the border effects that may occur in such LCD-displays.

### SUMMARY

There is provided a liquid crystal display which has a plurality of pixels that are arranged in a plurality of rows and a plurality of columns in a matrix form. Each pixel has a multiple of sub-pixels of first, second, third and fourth sub-pixel types, respectively, corresponding to red, green, blue and white (RGBW) colors and interleaved together. Each succession of the first, second, and third sub-pixels of the first, second and third sub-pixel types, respectively in first one of the rows form a first sub-pixel group and the subsequent fourth sub-pixel of the fourth type from the same row forms a second sub-pixel group. The sub-pixels are arranged such that the second type of sub-pixels and the fourth type of sub-pixels are in a same column. At each row, the sub-pixel in a rightmost column is of the same sub-pixel type as the sub-pixel in a leftmost column of that row. It has been found that such display arrangement reduces the border effects that may occur.

The display provided has sub-pixels that are not part of a complete sub-pixel group, which is consisted of one or more of the first sub-pixel group and the second sub-pixel group in succession. Such sub-pixels are configured to appear substantially black, thus reducing border effects.

According to the display provided, each row has at least one succession of the first and second sub-pixel groups consisting of the first, second, third and fourth types of sub-pixels.

According to the display provided, sub-pixels that are not part of a complete sub-pixel group are located at either a beginning or an end of each row.

According to the display provided, the first sub-pixel is a red sub-pixel, the second is a green sub-pixel, the third sub-pixel is a blue sub-pixel, and the fourth sub-pixel is a white sub-pixel or any other suitable color, such as yellow or cyan. It will be understood that other suitable colors for the sub-pixels can also be chosen.

According to the display provided, a first voltage V_{black} is supplied to the sub-pixels that are not part of the complete sub-pixel group, the first voltage V_{black} being arranged for setting the sub-pixels that are not part of the complete sub-pixel group, to a substantially black state to reduce border effects.

According to the display provided, the first voltage V_{black} is substantially zero.

According to the display provided, the sub-pixels are positioned in a frame forming a pattern with openings corresponding to each of the sub-pixels, with the frame covering the sub-pixels that are not part of a complete sub-pixel group. Such provides an easy to implement way of reducing border effects.

According to the display provided, the frame is substantially black.

According to a further aspect, there is a frame provided for use in a display. The frame has a plurality of openings arranged in a matrix, wherein the matrix has a pattern corresponding to a plurality fo sub-pixels in the display arranged in a plurality of columns and rows, and each leftmost opening of the mask corresponding to every other row of the plurality of rows is covered.

According to the frame provided, each rightmost opening of the mask corresponding to each row in between the above-mentioned every other row is covered.

According to the frame provided, the opening is of a substantially rectangular shape.

According to a further aspect, there is provided a display system which has a display panel with a plurality of pixels which are arranged in a plurality of rows and a plurality of columns in a matrix form; and a lighting unit operably configured to generate an illuminating light towards the display panel, wherein each of the pixels further includes a plurality of sub-pixels of first, second, third and forth types interleaved together. Each succession of first, second and third sub-pixels of the first, second and third types, respectively in first one of the rows, forms a first sub-pixel group, and a fourth sub-pixel of the fourth type from the same row forms a second sub-pixel group. Particularly, each row the sub-pixel in the rightmost column is of same type as the sub-pixel in the leftmost column, and the second type of the sub-pixels is arranged in the same column as the fourth type of the sub-pixels.

According to a further aspect the display system provided, a frame is added to the display system. The frame has a mask with a plurality of openings arranged in a matrix. Particularly, the matrix has a pattern corresponding to a plurality of sub-pixels in the display arranged in a plurality of columns and rows, whereby each leftmost opening of the mask corresponding to every other row is covered, and each rightmost opening of the mask corresponding to each row in between the every other row is also covered.

Acccording to the display system provided, a power source and a display controller are configured to supply data signals to the display panel for image display.

### BRIEF DESCRIPTION OF THE DRAWINGS

Embodiments of the invention will now be described, by way of example only, with reference to the accompanying schematic drawings in which corresponding reference symbols indicate corresponding parts, and in which:
Fig. 1 schematically depicts an LCD-display according to related art,
Fig. 2 schematically depicts an electrode lay-out of the LCD-display according to Fig. 1,

- Fig. 3 schematically depicts an LCD-display layout according to one embodiment,
- Fig. 4 schematically depicts an electrode lay-out of the LCD-display according to another embodiment,
- Fig. 5a schematically depicts an LCD-display according to related art,
- Fig. 5b schematically depicts an LCD-display according to yet annother embodiment, and
- Fig. 5c schematically depicts a frame according to Fig. 5b.
- Fig. 6 schematically shows an embodiment of a system.

### DETAILED DESCRIPTION

Embodiments are described here that minimize the border effects that may occur in LCD-displays.

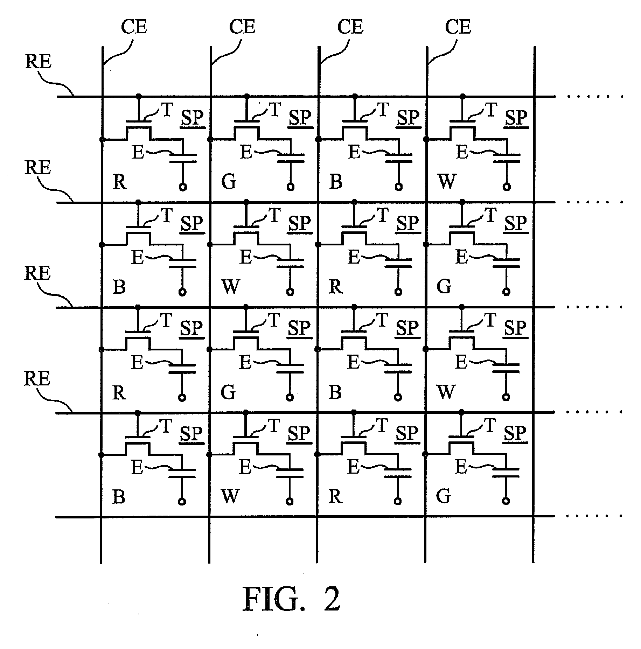

First, a conventional LCD-display DI as shown in Fig. 1 is explained in more detail in Fig. 2, which schematically depicts the circuit lay-out of the LCD-display DI. The red, green, blue and white sub-pixels SP are indicated with the letters R, G, B and W, respectively.

As explained above, in order to control a single sub-pixel SP, a network of column electrodes CE and row electrodes RE are provided. As shown in Fig. 2, the column electrodes CE run vertically and the row electrodes RE run horizontally. By applying a voltage to a column electrode CE and row electrode RE, the sub-pixel SP at the intersection is addressed. In order to optimize this addressing method, transistors T functioning as a switch are provided for each sub-pixel SP. Also, the transistors T prevent leakage of current during the period between successive addressing. The transistor T is generally formed by a thin film transistors (TFT), each of which can be arranged with a capacitor for compensating leakage during use.

Fig. 2 further depicts two corresponding electrodes E for each sub-pixel SP, forming a capacitor therebetween of which the electrical field through the liquid crystal is generated. However, as described above, the LCD-displays DI with an RGBW-arrangement can still suffer from border effects.

Additionally, in the processing of RGBW sub-pixels, the RGB sub-pixels may form a first group and the W sub-pixel may form a second group of sub-pixels. The advantage for such group formation is that the brightness, compared to a conventional RGB-pixel arrangement, is higher. The perceived resolution of an RGBW display using the sub-pixel rendering is dependent on the displayed image.

As a result, the far left blue sub-pixel SP of the second (and fourth, sixth, etc.) row as shown in Fig. 1 forms an incomplete first group of sub-pixels. Also, the far right red and green sub-pixels SP of the second (and fourth, sixth, etc.) row as shown in Fig. 1 form an incomplete first group of sub-pixels. Such provides an anomaly in the addressing the first column because there is no suitable data to drive the blue sub-pixels. Also, the color of the last pixel to be displayed in the even rows is problematic because the blue sub-pixel is missing. Such may result in deterioration of the quality of the image. Also, if random data were used, random colors can be generated accordingly.

In order to reduce and minimize the border effects as described above, embodiments further are provided hereinbelow.

### Embodiment 1

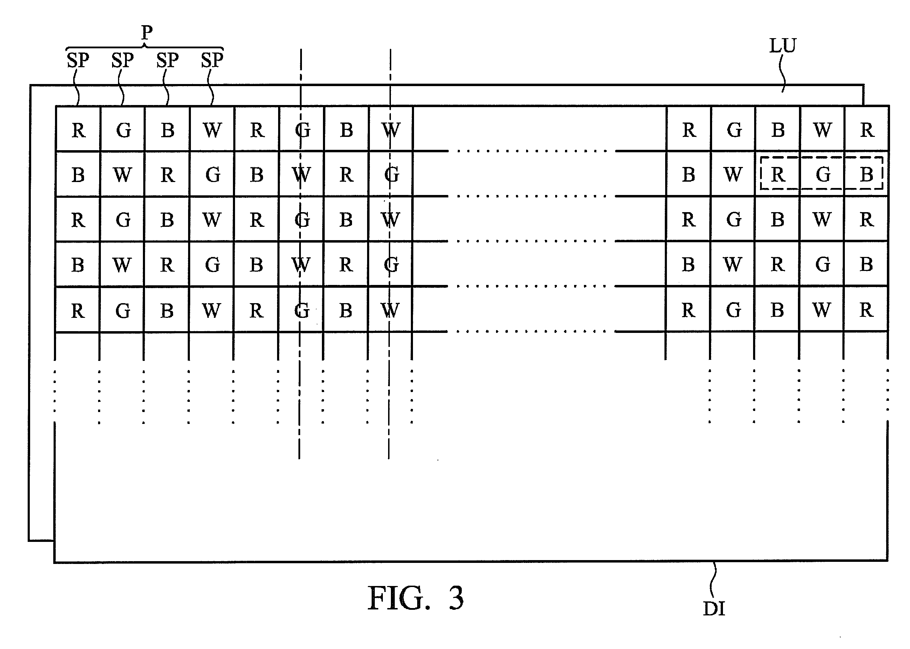

Fig. 3 schematically depicts an LCD-display layout according to a first embodiment. In Fig. 3, entities with the same reference number as shown in the preceding figures refer to the corresponding entities in the preceding figures.

According to the first embodiment, a display is provided in which one or more additional columns with sub-pixels are added such that the first group of sub-pixels(R,G,B) at the right-hand side in the even rows is now completed.

In comparison to the exemplary arrangement of Fig. 1, the display shown in Fig. 3 has, on each even row in the rightmost column, a blue sub-pixel B which completes the first group of sub-pixels in that row (see the dotted square in Fig. 3). Additionally, in the odd rows in the rightmost column, a red sub-pixel R is incorporated. In each row, the sub-pixel in a rightmost column is of the same color or sub-pixel type as the sub-pixel in a leftmost column of that row.

Unlike the incomplete first groups of sub-pixels in the even rows (i.e., red and green subpixels) as shown in Fig. 1, first groups of sub-pixels are now (i.e., a single red subpixel) in the odd rows, as shown in Fig. 3. However, the border effect generated by the single sub-pixel in the odd rows of Fig. 3 is smaller than the border effect generated by the incomplete groups of sub-pixels according to Fig. 1 with two sub-pixels. Additionally, due to the fact that a complete first group of sub-pixels red, green and blue is now present in the even rows, the user perception on the right-hand side of the display for the even rows is greatly improved.

### Embodiment 2

According to a second embodiment, incomplete sub-pixels SP, which are not part of a complete sub-group of pixels, are driven by using a black level voltage V_{black}, such that these incomplete sub-pixels SP are always in a dark (opaque or non-transparent) state. These sub-pixels are usually located at the beginning or end of a row, as can be seen in Fig. 2. Of course, this embodiment may also be employed to the left-hand side for the arrangement as shown in Fig. 1.

According to this embodiment, the incomplete sub-pixels are driven by using a V_{black} voltage when the corresponding gate line is addressed (transistors turned on). More specifically, referring to Fig.3, the incomplete sub-pixels (i.e., the blue sub-pixels in the leftmost column of even rows, and red sub-pixels in the rightmost column of odd rows) can be driven by the same method as the other sub-pixels, so that standard display drivers can be used and a normal driving scheme may be utilized.

This embodiment can also employ both 'normally white' LCD-displays and 'normally black' LCD-displays.

### Embodiment 3

According to a further embodiment, incomplete sub-pixels SP, which are not part of a complete sub-group of pixels, are decoupled from addressing. These sub-pixels are usually located at the beginning or end of a row.

This embodiment does not need a special mask and first voltage V_{black} to make the not-used sub-pixels substantially black. According to this embodiment, specific sub-pixels may easily decoupled from an addressing mode with a small change to the mask.

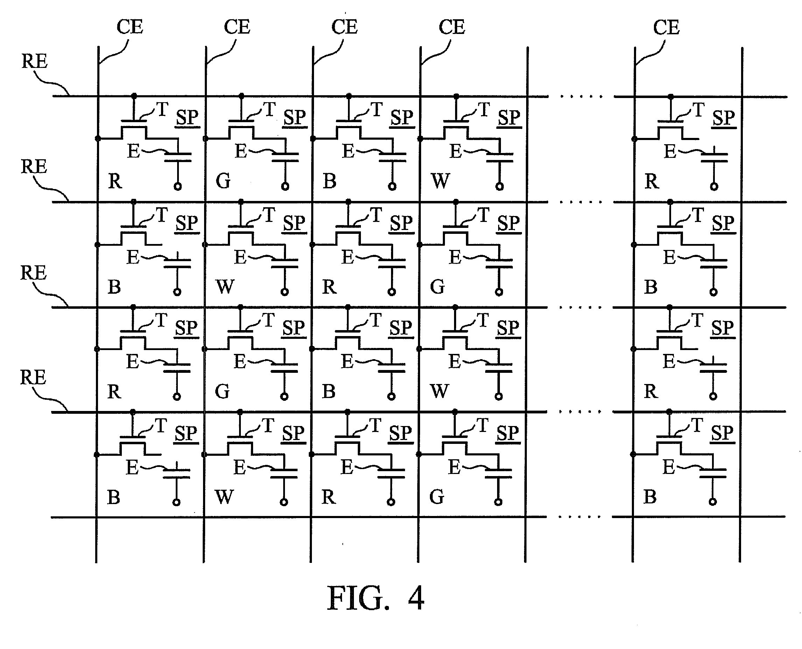

This embodiment is schematically shown in Fig. 4, where it is shown that the electrodes E are decoupled (i.e., the blue sub-pixels in the leftmost column of even rows, and red sub-pixels in the rightmost column of odd rows). This embodiment is suitable for use in a so-called 'normally black' LCD-display DI, i.e. a LCD-display DI in which pixels or sub-pixels appear substantially black when no voltage is applied.

### Embodiment 4

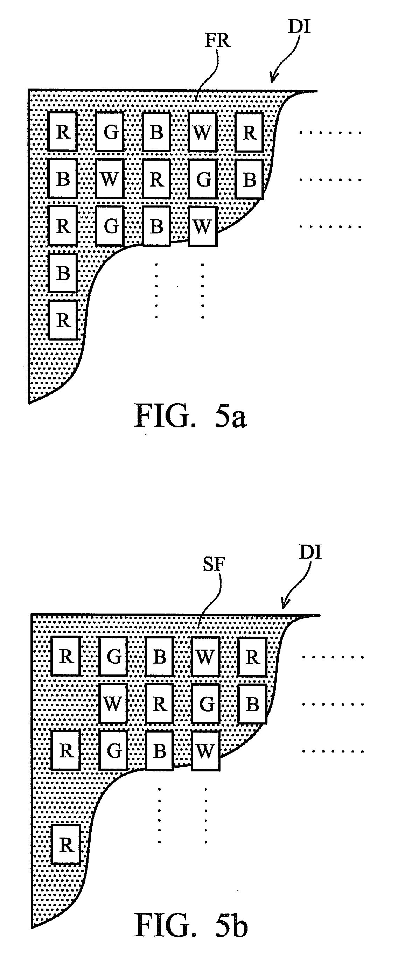

The sub-pixels SP of a LCD-display are usually positioned in a frame FR. Frame FR, as schematically depicted in Fig. 5a, forms a pattern with openings, each opening corresponding to a sub-pixel SP. For instance, the frame can have a pattern, with rectangular or square shaped openings. The frame FR is substantially black.

According to this embodiment, a staggered frame SF is provided, covering the sub-pixels SP, which are not part of a complete sub-group of pixels. These sub-pixels SP are usually located at the beginning or end of a row. Therefore, openings that correspond to sub-pixels SP at the beginning or end of a row, which are not part of a complete sub-group of pixels, are omitted.

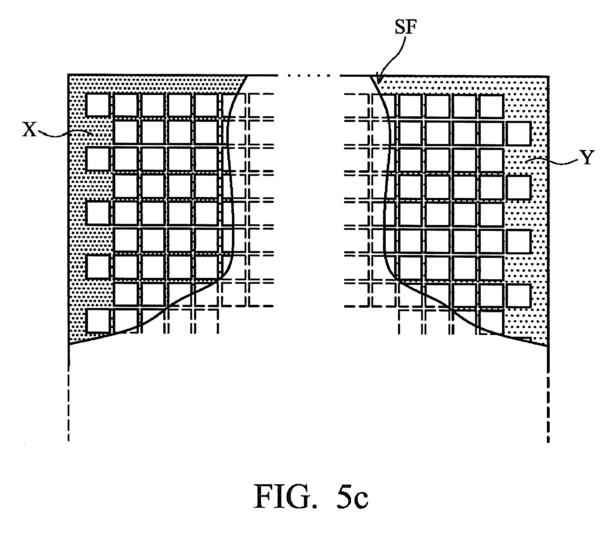

This is schematically depicted in Fig. 5b, showing the LCD-display LCD of Fig. 3 with a staggered frame SF, covering the sub-pixels of incomplete groups at left side of the even rows and at the right side of odd rows (not shown). An example of a staggered frame SF which can be used for a display as described above with reference to the first embodiment is depicted in Fig. 5c.

According to this embodiment, there is provided a frame with a plurality of openings arranged in a matrix. The matrix includes a plurality of rows wherein each first opening on every other row is covered or closed. Also, each last opening on each row in between the every other row can also be covered or closed.

According to this embodiment, no adjustments need to be made in addressing the sub-pixels SP. Thus, the load of the first column electrode CE (and last column electrode CE) is equal to the other column electrodes CE. Therefore, this solution will not give any other artifact. Furthermore, this embodiment ensures a minimum of light leakage, especially at large viewing angles.

It will be understood that this embodiment may be used in combination with the other embodiments as described above.

The embodiments as described above may be applied in many technical fields, such as mobile display, telecom, and personal digital assistant (PDA) that use the RGBW arrangement instead of the RGB arrangement display technology. Also, in the near future, TV-on-Mobile devices are targeted to implement the RGBW arrangement.

It will be understood that the embodiments 2, 3 and 4, described with respect to Figs. 4, 5a, 5b and 5c, may be applied to any kind of display arrangement, such as shown in Fig. 1 as well as Fig. 3. The proposed embodiments may be used to make sub-pixels that are not part of a complete sub-pixel group to appear substantially black. In the proposed embodiments, a lighting unit (LU), as shown in Fig. 3, may be operably configured to generate an illuminating light towards the display.

Also, the embodiments and figures use terms as 'even' and 'odd' rows. However, it will be understood that these terms may also be used the other way around.

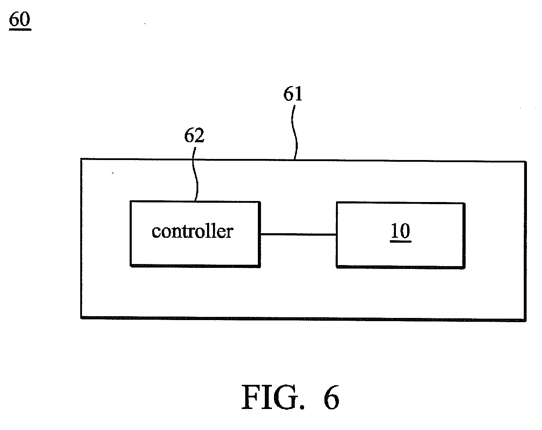

Therefore, according to an embodiment, there is provided a system which includes an LCD-display and frame according to the embodiments described above. Please refer to Fig. 6, a system for displaying image 60 may be a digital camera, a portable DVD, a television, a car display, a PDA, notebook computer, tablet computer, cellular phone, notebook, global positing system, automatic display, avionics display, mobile phone, telecom, digital photo frame or a display device, etc.

Generally, the system for displaying image 60 includes display panel 10, a housing 61, and a controller 62 which maybe includes a power source and a display controller, although it is to be understood that various other components can be included; however, such other components are not shown or described here for ease of illustration and description. In operation, controller 62 is operatively coupled to display panel 10 and provides control signals, such as clock signals, start pulses, or image data, etc, to display panel 10.

It will be understood that the embodiments described above are described with reference to LCD-displays DI. However, it will be understood that the embodiments may also be used for other types of displays, such as LED-displays (LED: Light Emitting Diode) and OLED-displays (OLED: organic LED-displays), having a similar sub-pixel arrangement.

As explained above, instead of a white sub-pixel, also other suitable colors may be chosen, such as yellow or cyan.

The descriptions set forth above are intended to be illustrative, not limiting. Thus, it will be apparent to one skilled in the art that modifications can be made to the invention as described without departing from the scope of the claims as set out below.

## Claims

1. A display having a plurality of pixels which are arranged in a plurality of rows (RE) and a plurality of columns (CE) in a matrix form, each of said pixels comprising:
a plurality of sub-pixels (SP) of first, second, third and forth types interleaved together, wherein
each succession of first, second and third sub-pixels of said first, second and third types, respectively, in a first one of said rows, forms a first sub-pixel group, and a fourth sub-pixel of said fourth type from the same row forms a second sub-pixel group,
for each row, the sub-pixel at the rightmost column is of same type as the sub-pixel at the leftmost column, and
the second type of the sub-pixels is arranged in the same column as the fourth type of the sub-pixels.

2. The display according to claim 1, wherein one or more sub-pixels that are not part of a complete sub-pixel group, which is consisted of one or more of the first sub-pixel group and the second sub-pixel group in succession, are configured to appear substantially black.

3. The display according to claim 1 or 2, wherein each row comprises at least one succession of the first and second sub-pixel groups consisting of the first, second, third and fourth types of sub-pixels.

4. The display according to claim 1, wherein one or more sub-pixels that are not part of a complete sub-pixel group, which is consisted of one or more of the first sub-pixel group and the second sub-pixel group in succession, are located at either a beginning or an end of said rows.

5. The display according to any of the preceding claims, wherein the first type of sub-pixels is of a red color ®, the second type of sub-pixels is of a green color (G), the third type of sub-pixels is of a blue color (B) and the fourth type of sub-pixel is of a white color (W) or a yellow color or a cyan color.

6. The display according to claim 2, wherein a first voltage V_{black} is supplied to the sub-pixels that are not part of the complete sub-pixel group, the first voltage V_{black} being arranged for setting the sub-pixels that are not part of the complete sub-pixel group to a substantially black state.

7. The display according to claim 6, wherein the first voltage V_{black} is substantially zero.

8. The display according to claim 2, wherein said plurality of the sub-pixels are positioned in a frame (FR) forming a pattern with openings corresponding to each of the sub-pixels, the frame covering said one or more of the sub-pixels that are not part of the complete sub-pixel group.

9. The display according to claim 8, in which the frame is substantially black.

10. The display according to claim 1, wherein one or more sub-pixels that are not part of a complete sub-pixel group, which is consisted of one or more of the first sub-pixel group and the second sub-pixel group in succession are decoupled from a corresponding address line of said display.

11. The display according to claim 1, wherein for each even row, the sub-pixel at the leftmost column is decoupled from a corresponding address line of said display, and for each odd row, the sub-pixel at the rightmost column is decoupled from another corresponding address line of said display.

12. The display according to claim 1, wherein for each even row, the sub-pixel at the leftmost column is supplied with a V_{black} voltage, and for each odd row, the sub-pixel at the rightmost column is supplied with said V_{black} voltage.

13. The display according to any of the preceding claims, further comprising a frame (FR) with a plurality of openings arranged in a matrix having a plurality of column and rows, wherein each leftmost opening or each rightmost opening in every other of said rows is covered.

14. A display system, comprising:
a display or display panel according to any of the preceding claims; and
a lighting unit operably configured to generate an illuminating light towards said display or display panel.

15. The display system according to claim 14, further comprising a frame (FR) for use in a liquid crystal display, said frame comprising:
a mask with a plurality of openings arranged in a matrix, wherein
said matrix has a pattern corresponding to a plurality of sub-pixels in the display arranged in a plurality of columns and rows, and
each leftmost opening of said mask corresponding to every other row of said plurality of rows is covered.
